# EUROPÄISCHE PATENTSCHRIFT

(11) **EP 2 567 459 B1**
(45) Veröffentlichungstag und Bekanntmachung des Hinweises auf die Patenterteilung: **21.05.2014**
(21) Anmeldenummer: 11707188.6
(22) Anmeldetag: 10.03.2011
(51) Int. Cl.: H03K 17/955

(54) **ERFASSUNG EINES DIELEKTRISCHEN OBJEKTS**
DETECTION OF A DIELECTRIC OBJECT
DETECTION D'UN OBJET DIELECTRIQUE

(30) Priorität: 07.05.2010 DE 102010028718
(43) Veröffentlichungstag der Anmeldung: 13.03.2013
(73) Patentinhaber: Robert Bosch GmbH, 70442 Stuttgart (DE)
(72) Erfinder: ZIBOLD, Tobias, 70567 Stuttgart (DE); ALBRECHT, Andrej, 70567 Stuttgart (DE)
(86) Internationale Anmeldenummer: PCT/EP2011/053617
(87) Internationale Veröffentlichungsnummer: WO 2011/138081

(56) Entgegenhaltungen:
- WO-A1-98/07051
- WO-A1-98/26506
- US-A- 5 373 245

## Beschreibung

Die Erfindung betrifft einen Detektor für ein dielektrisches Objekt. Insbesondere betrifft die Erfindung eine Messvorrichtung zur Erfassung eines dielektrischen Objekts mit den Merkmalen des Oberbegriffs von Anspruch 1.

### Stand der Technik

Zur Erfassung eines in einer Wand verborgenen Gegenstandes wie einen in einer Wand verborgenen Balken sind kapazitive Detektoren im Stand der Technik bekannt. Diese verwenden häufig eine Elektrode, deren Aufladeverhalten beobachtet wird, um auf das dielektrische Objekt zu schließen. Es sind auch Detektoren mit mehreren Elektroden bekannt, wobei eine Änderung der Kapazität von Elektrodenpaaren bestimmt wird. Üblicherweise ist es notwendig, diese Detektoren auf der Wand manuell zu kalibrieren, da die Geräte den Wandkontakt nicht selbst erkennen können und die Kapazität von Umgebungsbedingungen wie einer Feuchtigkeit der Wand, einer Luftfeuchtigkeit oder einer Umgebungstemperatur abhängt. Es ist daher nicht möglich, derartige Detektoren einmalig bei der Herstellung zu kalibrieren, stattdessen muss die Kalibrierung relativ zeitnah vor einer Messung durch einen Benutzer durchgeführt werden. Dabei hängt ein Messergebnis von der Qualität der Kalibrierung ab. Wird der Detektor mit Wandkontakt an einer Stelle kalibriert, in deren Bereich sich ein Balken befindet, kann ein späteres Messergebnis mehrdeutig sein, was einen Benutzer verwirren kann.

Ferner sind die beschriebenen Detektoren anfällig gegenüber einem Verkippen auf der Wand. Durch Verkippen sind Abstände mehrerer Elektroden zur Wand ungleich, so dass gemessene Kapazitäten einem Fehler unterliegen. Darüber hinaus nimmt die an den Elektroden gemessene Kapazität bei Annäherung der beschriebenen Detektoren an die Wand nicht monoton zu, so dass der Abstand von der Wand und eine Annäherung bzw. Entfernung des Detektors von der Wand schlecht nachvollziehbar sein kann.

DE 10 2008 005 783 A1 beschreibt eine feuchteunabhängige kapazitive Vorrichtung zum Schutz vor Einklemmen. Ein Einklemmsensor umfasst zwei Elektroden mit variablem Abstand. Der Einklemmsensor und eine Schaltung mit konstanter Kapazität werden mit alternierenden Spannungen versorgt, wobei die Spannungen derart verstärkt bzw. abgeschwächt werden, dass eine Spannung an einer der Elektroden des Einklemmsensors minimiert ist. Wird der relative Abstand der Elektroden verändert, so wird ein Einklemmen auf der Basis einer angestiegenen Spannung an der Elektrode erfasst.

WO 98/26506 A1 zeigteine Messvorrichtung zur Erfassung einer Berührung durch einen Benutzer. Dabei werden eine Kapazitätseinrichtung mit einer alternierenden Spannung versorgt und ein Einfluss des Benutzers auf eine Potentialsonde in einem elektrischen Feld bestimmt.

Der Erfindung liegt die Aufgabe zugrunde, einen einfachen und genauen Detektor für ein dielektrisches Objekt, z.B. ein Holzbalken in einer Wand, bereitzustellen.

### Offenbarung der Erfindung

Die Erfindung löst diese Aufgabe mittels einer Messvorrichtung mit den Merkmalen des Anspruchs 1 und durch ein Verfahren mit den Merkmalen des Anspruchs 10. Unteransprüche geben bevorzugte Ausführungsformen an.

Erfindungsgemäß umfasst eine Messvorrichtung zur Erfassung eines dielektrischen Objekts eine Potentialsonde zum Bestimmen eines elektrischen Potentials in einem elektrischen Feld, eine erste und eine zweite Kapazitätseinrichtung und eine Steuereinrichtung zur Versorgung der ersten und zweiten Kapazitätseinrichtung mit alternierenden Spannungen. Die Steuereinrichtung ist dazu eingerichtet, die alternierenden Spannungen zueinander gegenläufig zu verstärken, um einen zu den alternierenden Spannungen taktsynchronen Wechselspannungsanteil einer mittels der Potentialsonde aufgenommene Spannung betragsmäßig zu minimieren. Das dielektrische Objekt wird erfasst, wenn die alternierenden Spannungen ungleich groß sind.

Die erfindungsgemäße Messvorrichtung bestimmt einen Unterschied zweier Kapazitäten, so dass Störeinflüsse, die beide Kapazitäten betreffen, das Messergebnis nicht beeinflussen. Dabei kann jede der Kapazitätseinrichtungen eine Elektrode umfassen, die zusammen mit einer Elektrode der Potentialsonde eine Kapazität bildet. Eine Kalibrierung der Messvorrichtung durch einen Benutzer kann entfallen und die Kalibrierung kann einmalig durchgeführt werden, etwa im Rahmen der Herstellung der Messvorrichtung. Da die Kalibrierung auf der Wand entfällt, kann ein Objekt auch dann unmittelbar und zuverlässig erfasst werden, wenn das Gerät im Bereich des Objekts auf die Wand aufgesetzt wird.

Vorzugsweise sind die Elektroden der ersten und zweiten Kapazitätseinrichtung im Wesentlichen in einer Ebene angeordnet und die Elektrode der Potentialsonde ist außerhalb dieser Ebene angeordnet. Die relative Abstandsänderung der Elektroden beim Verkippen ist im Verhältnis zum Gesamtabstand der Elektroden zur Wand klein im Vergleich zu einer Anordnung, bei der die Sendeelektroden unmittelbar auf der Wand aufliegen. Bei einem Verkippen der Messeinrichtung bezüglich der Wand kann die relative Kapazitätsänderung der Kapazitätseinrichtungen minimiert sein, so dass ein Messfehler minimiert ist.

Die Potentialsonde kann zwei mit einem Differenzverstärker verbundene Empfangselektroden umfassen, wobei die Empfangselektroden auf unterschiedlichen Seiten der Ebene mit Abständen, vorzugsweise gleichen Abständen, zur ersten und zweiten Kapazitätseinrichtung angeordnet sind. Der Differenzverstärker kann zusätzlich einen Hochpass umfassen. Das vom Differenzverstärker bereitgestellte Signal ist durch die differentielle Messung unempfindlich gegenüber Fremdeinflüssen wie einer potentialbehafteten oder leitfähigen Wand. Darüber hinaus ist die somit durchgeführte feldkompensierte Messung sehr genau. Ein Vorzeichen des Signals weist auf eine relative Lage des dielektrischen Objekts hin, so dass ein Auffinden des dielektrischen Objekts erleichtert sein kann. Ein Vorzeichenwechsel (Nulldurchgang) weist auf die Mitte des Balkens hin. Ein Einfluss eines Verkippens kann wie bei dem oben beschriebenen Aufbau minimiert sein.

Auf einer von dem dielektrischen Objekt abgewandten Seite wenigstens einer der Kapazitätseinrichtungen kann eine Abschirmelektrode angeordnet sein, die mit einem Potential verbunden ist, das mittig zwischen den alternierenden Spannungen liegt. Diese Abschirmelektrode kann z.B. auch eine weiter Platine oder ein Display sein und damit als Abschirmelektrode nicht unmittelbar erkennbar sein. Im Allgemeinen wird dieses Potential Masse sein. Ein Benutzer der Messvorrichtung ist so gegenüber der Messeinrichtung abgeschirmt, so dass Störungen der Messung minimiert sein können.

Eine der Kapazitätseinrichtungen kann derart aufgebaut sein, dass die zwischen dieser Kapazitätseinrichtung und der Potentialsonde bestehende Kapazität von dem dielektrischen Objekt unabhängig ist. Somit kann die Messung auf der Basis von lediglich einer von dem dielektrischen Objekt abhängigen Kapazität durchgeführt werden, wodurch ein Aufbau der Messeinrichtung vereinfacht sein kann. Insbesondere kann eine solche Messeinrichtung unempfindlich gegenüber Verkippen sein, da die Potentialsonde das gleiche Potential wie die Elektrode annehmen kann, so dass sich das ergebende elektrische Feld durch das elektrische Feld der Potentialsonde nicht verändert.

Es kann ein Kompensationsnetzwerk zur Veränderung wenigstens einer der durch die Kapazitätseinrichtungen bereitgestellten Kapazitäten um einen von dem dielektrischen Objekt unabhängigen Betrag vorgesehen sein. Dadurch kann eine Empfindlichkeit der Messvorrichtung einstellbar und Kapazitäten der Kapazitätseinrichtungen an beispielsweise geometrische Gegebenheiten anpassbar sein.

Ferner kann eine Vielzahl Elektrodenpaare der Kapazitätseinrichtungen vorgesehen sein, die sich z.B. paarweise auf unterschiedlichen Seiten der Potentialsonde befinden, wobei die Steuereinrichtung dazu eingerichtet ist, wenigstens eines von einer Größe, einer Ausdehnung, einer Entfernung und einer Richtung des dielektrischen Objekts auf der Basis von Differenzen der alternierenden Spannungen zu bestimmen, wenn unterschiedliche Elektrodenpaare mit den alternierenden Spannungen versorgt sind. Durch Miniaturisierung der Elektroden kann eine räumliche Auflösung der Messvorrichtung gesteigert sein, in einer Ausführungsform bis in einen bildgebenden Bereich. Vorzugsweise sind die Elektroden der Elektrodenpaare in einer Ebene matrixartig um die Potentialsonde herum angeordnet.

Ein Verfahren zur Erfassung eines dielektrischen Objekts umfasst Schritte des Bestimmens eines elektrischen Potentials in einem elektrischen Feld mittels einer Potentialsonde, des Versorgens zweier Kapazitätseinrichtungen mit gegenläufig verstärkten alternierenden Spannungen derart, dass ein zu den alternierenden Spannungen taktsynchroner Wechselspannungsanteil des bestimmten elektrischen Potentials betragsmäßig minimiert ist, und des Erfassens des dielektrischen Objekts, wenn die alternierenden Spannungen ungleich groß sind.

Das Verfahren kann auf einer programmgesteuerten Verarbeitungseinrichtung, beispielsweise einem Mikrocomputer oder Mikrocontroller, ablaufen oder auf einem computerlesbaren Speichermedium gespeicher sein.

### Kurze Beschreibung der Figuren:

Im Folgenden wird die Erfindung mit Bezug auf die beigefügten Figuren genauer beschrieben, in denen:
- Figur 1: ein Blockschaltbild einer Messvorrichtung;
- Figuren 2a-2b: verschiedene Anordnungen von Elektroden für die Messvorrichtung aus Figur 1;
- Figuren 3a, 3b: eine Potentialsonde für die Messvorrichtung aus Figur 1;
- Figur 4: eine weitere Anordnung von Elektroden für die Messvorrichtung aus Figur 1; und
- Figur 5: ein Ablaufdiagramm eines Verfahrens zur Erfassung eines dielektrischen Objekts
darstellt.

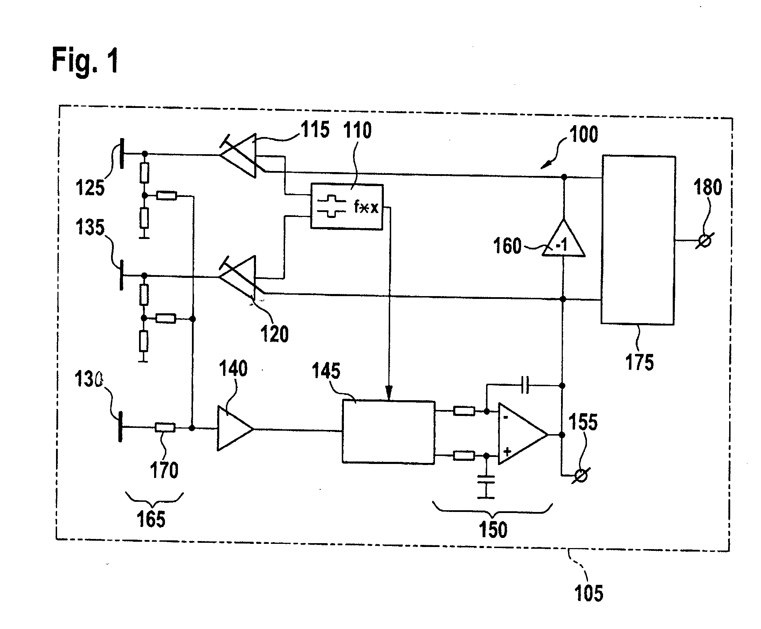

Figur 1 zeigt ein Blockschaltbild einer Messvorrichtung 100. Die Messvorrichtung 100 ist Teil eines Balkenfinders 105 zum Erfassen dielektrischer Objekte, beispielsweise aus Holz.

Ein Taktgenerator 110 hat zwei Ausgänge, an denen er phasenverschobene, vorzugsweise um 180° phasenverschobene, periodische Wechselsignale bereitstellt. Die Wechselsignale können insbesondere Rechteck-, Dreieck- oder Sinussignale umfassen. Die Ausgänge des Taktgenerators sind mit einem ersten steu erbaren Verstärker 115 bzw. einem zweiten steuerbaren Verstärker 120 verbunden. Jeder der steuerbaren Verstärker 115, 120 verfügt über einen Steuereingang, über den er ein Signal entgegennimmt, welches einen Verstärkungsfaktor des steuerbaren Verstärkers 115, 120 steuert. Ein Ausgang des ersten steuerbaren Verstärkers 115 ist mit einer ersten Sendeelektrode 125 und ein Ausgang des zweiten steuerbaren Verstärkers 120 mit einer zweiten Sendeelektrode 130 verbunden.

Eine Empfangselektrode 135 dient als Potentialsonde und ist mit einem Eingangsverstärker 140 verbunden; ein im Bereich der Elektroden 125-135 dargestelltes Kompensationsnetzwerk 165 wird zunächst nicht betrachtet und eine Impedanz 170 entfällt. Der Eingangsverstärker 140 ist mit einem konstanten Verstärkungsfaktor dargestellt; in anderen Ausführungsformen kann jedoch ein Verstärkungsfaktor des Eingangsverstärkers 140 auch steuerbar sein. Dadurch kann beispielsweise eine räumliche Auflösung und/oder Empfindlichkeit der Messvorrichtung 100 beeinflussbar und beispielsweise in Abhängigkeit einer Messgröße steuerbar sein.

Der Ausgang des Eingangsverstärkers 140 ist mit einem Synchrondemodulator 145 verbunden. Der Synchrondemodulator 145 ist ferner mit dem Taktgenerator 110 verbunden und empfängt von diesem ein Taktsignal, welches auf die Phasenlage der an den Ausgängen des Taktgenerators 110 bereitgestellten Signale hinweist. In einer einfachen Ausführungsform, bei der die vom Taktgenerator 110 bereitgestellten Signale symmetrische Rechtecksignale sind, kann eines der Ausgangssignale als Taktsignal verwendet werden. Der Synchrondemodulator 145 schaltet im Wesentlichen auf der Basis des vom Taktgenerator 110 bereitgestellten Taktsignals das vom Eingangsverstärker 140 empfangene Messsignal alternierend an seinem oberen bzw. unteren Ausgang durch.

Die beiden Ausgänge des Synchrondemodulators 145 sind mit einem Integrator (integrierenden Komparator) 150 verbunden, der hier als mit zwei Widerständen und zwei Kondensatoren beschalteter Operationsverstärker dargestellt ist. Andere Ausführungsformen sind ebenfalls möglich, beispielsweise als aktiver Tiefpass. Auch eine digitale Ausführung im Anschluss an den Synchrondemodulator 145 ist denkbar, bei der das Signal an den Ausgängen des Synchrondemodulators 145 zu einem oder mehreren Zeitpunkten innerhalb einer Halbwelle analog zu digital gewandelt wird und dann mit dem entsprechenden Wert aus der nächsten Halbwelle verglichen wird. Die Differenz wird integriert und z.B. wieder in ein analoges Signal überführt und zur Steuerung der Verstärker verwendet. Während der Synchrondemodulator 145 das vom Eingangsverstärker 140 empfangene Messsignal am unteren seiner Ausgänge bereitstellt, integriert der Integrator 150 dieses Signal über die Zeit und stellt das Resultat an seinem Ausgang bereit. Während der Synchrondemodulator 145 das vom Eingangsverstärker 140 empfangene Messsignal an seinem oberen Ausgang bereitstellt, wird dieses vom Integrator 150 invertiert über die Zeit integriert und das Resultat am Ausgang des Integrators 150 bereitgestellt. Die Spannung am Ausgang des Integrators ist das Integral der Differenz der tiefpassgefilterten Ausgänge des Synchrondemodulators.

Ist die Kapazität der ersten Sendeelektrode 125 genau so groß wie die Kapazität der zweiten Sendeelektrode 130, so sind die an den Ausgängen des Synchrondemodulators 145 bereitgestellten Signale im Mittel über die Zeit gleich groß und am Ausgang des Integrators 150 wird ein Signal bereitgestellt, das gegen Null (Masse) geht. Sind jedoch die Kapazitäten ungleich groß, etwa weil ein dielektrisches Objekt im Bereich einer der Sendeelektroden 125, 130 angeordnet ist, so sind die an den Ausgängen des Synchrondemodulators 145 bereitgestellten Signale im Mittel nicht mehr gleich, und am Ausgang des Integrators 150 wird ein positives oder negatives Signal bereitgestellt.

Das vom Integrator 150 bereitgestellte Signal wird über einen Anschluss 155 zur weiteren Verarbeitung bereitgestellt. Zusätzlich ist ein Mikrocomputer 175 mit den Steuereingängen der steuerbaren Verstärker 115, 120 verbunden. Der Mikrocomputer 165 führt einen Vergleich des bereitgestellten Signals mit einem Schwellenwert durch und gibt an einem Ausgang 180 ein Signal aus, welches auf das dielektrische Objekt hinweist. Das Signal kann in optischer und/oder akustischer Weise einem Benutzer des Balkendetektors 105 dargeboten werden.

Der Mikrocomputer 165 kann darüber hinaus eine weitere Verarbeitung der von den Steuereingängen der steuerbaren Verstärker 115, 120 abgegriffenen Signale durchführen und in deren Abhängigkeit Parameter der Messvorrichtung 100 steuern. Beispielsweise kann eine Frequenz oder Signalform der alternierenden Spannungen an den Ausgängen des Taktgenerators 110 variiiert oder eine Emp findlichkeit des Empfangsverstärkers 140 geändert werden. In einer weiteren Ausführungsform sind weitere der gezeigten Elemente der Messvorrichtung 100 durch den Mikrocomputer 165 implementiert, etwa der Taktgenerator 110, der Synchrondemodulator 145 oder der Integrator 150.

Das gleiche Signal des Integrators 150 wird auch zur Steuerung der Verstärkungsfaktoren der steuerbaren Verstärker 115 und 120 verwendet, wobei der zweite steuerbare Verstärker 120 unmittelbar mit dem Ausgang des Integrators 150 verbunden ist und der erste steuerbare Verstärker 115 mittels eines Inverters 160 mit dem Ausgang des Integrators 150 verbunden ist. Der Inverter 160 bewirkt eine Umkehrung des ihm bereitgestellten Signals derart, dass in Abhängigkeit des Ausgangssignals des Integrators 150 der Verstärkungsfaktor des ersten steuerbaren Verstärkers 115 in dem Maß zunimmt wie der Verstärkungsfaktor des zweiten steuerbaren Verstärkers 120 abnimmt bzw. umgekehrt. Es ist auch denkbar, dass nur der Verstärkungsfaktor eines der steuerbaren Verstärker gesteuert wird, während der Verstärkungsfaktor des zweiten steuerbaren Verstärkes auf einem festen Wert gehalten wird.

Das Kompensationsnetzwerk 165 umfasst an jeder der Sendeelektroden 125, 130 einen aus zwei Impedanzen bestehenden Spannungsteiler. Die geteilten Spannungen werden mittels jeweils einer weiteren Impedanz an den Eingangsverstärker 140 geführt. Die Empfangselektrode 135 ist nicht direkt sondern mittels der Impedanz 170 an den Eingangsverstärker 140 geführt. Durch entsprechende Wahl der einzelnen genannten Impedanzen können die an den Ausgängen der steuerbaren Verstärker 115, 120 wirksamen Impedanzen verändert werden. Hierdurch kann beispielsweise eine asymmetrische Anordnung der Elektroden 125-135 kompensiert werden.

Durch Vorsehen von Schaltern kann die Messvorrichtung 100 entsprechend der beschriebenen Ausführungsformen in einem Drei-Elektroden-Messbetrieb unter Verwendung beider Sendeelektroden 125 und 130, einem ersten Zwei-Elektroden-Messbetrieb unter Verwendung der ersten Sendeelektrode 125 und der Empfangselektrode 135 sowie einem zweiten Zwei-Elektroden-Messbetrieb unter Verwendung der zweiten Sendeelektrode 130 und der Empfangselektrode 135 betrieben werden. Eine Umschaltung zwischen den unterschiedlichen Messbetrieben kann zyklisch erfolgen oder durch einen Benutzer gesteuert sein.

Während im Zwei-Elektroden-Messbetrieb eine am Anschluss 155 der Messvorrichtung 100 in Figur 1 anliegende Spannung dann am größten ist, wenn das dielektrische Objekt der Empfangselektrode 135 am nächsten ist, ist im Drei-Elektroden-Messbetrieb der Betrag dieser Spannung dann maximal, wenn das dielektrische Objekt einer der Sendeelektroden 125 oder 130 am nächsten ist, wobei das Vorzeichen der Spannung auf die jeweils nächstliegende Sendeelektrode hinweist. Wird das Objekt an den Elektroden vorbei bewegt, ergibt sich also im Drei-Elektroden-Messbetrieb ein Signal mit einem Vorzeichenwechsel und im Zwei-Elektroden-Messbetrieb ein Signal mit einem lokalen Maximum im Moment des Passierens.

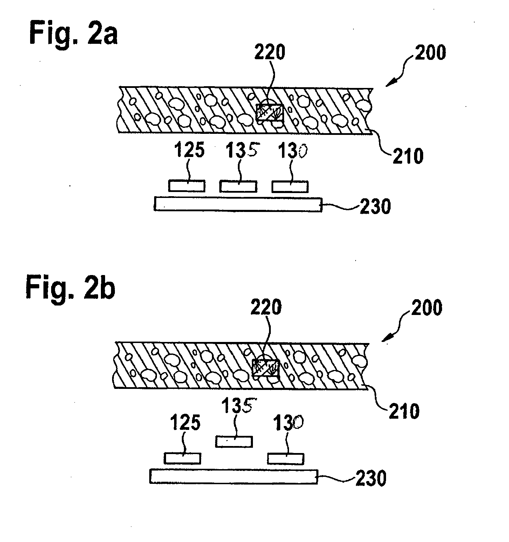

Figuren 2a-2b zeigen verschiedene Anordnungen 200 der Sendeelektroden 125, 130 und der Empfangselektrode 130 aus Figur 1. Die Blickrichtung ist bodenwärts. Im oberen Bereich der Figuren 2a-2b ist jeweils eine Draufsicht auf einen horizontalen Schnitt durch eine Wand 210 eingezeichnet. In der Wand 210 sind Holzbalken 220 verborgen. Die gezeigten Anordnungen 200, insbesondere diejenige der Figur 2b, sind universell für kapazitive Balkenfinder mit mehreren Elektroden verwendbar und nicht auf die Verwendung mit dem Balkenfinder 105 aus Fig. 1 beschränkt.

In Figur 2a sind die Elektroden 125-130 in einer Ebene nebeneinander angeordnet; Abstände der Empfangselektrode 130 von jeder der Sendeelektroden 125, 130 sind gleich. Zur Abschirmung gegenüber Einflüssen, die von einer anderen Richtung als der Richtung der Wand 210 kommen, kann optional eine Abschirmelektrode 230 vorgesehen sein, die unterhalb der Elektrode 125-135 angeordnet ist.

In Figur 2b ist im Unterschied zur Darstellung in Figur 2a die Empfangselektrode 130 außerhalb der Ebene angeordnet, in der die Sendeelektroden 125, 135 liegen. In der Darstellung ist die Empfangselektrode 130 oberhalb der Ebene dargestellt, in einer alternativen Ausführungsform kann sie auch darunter liegen. Bei einem Verkippen der Messeinrichtung 100 mit den Elektroden 125-135 und optional der Abschirmelektrode 230 um eine zur Wand 210 parallele Hochachse ist die relative Feldänderung am Ort der Empfangselektrode 130 geringer als bei der Anordnung 200 in Figur 2a, da die Feldstärken der mittels der Sendeelektroden 125, 135 generierten elektrischen Felder mit zunehmendem Abstand kleiner werden. Der verringerte Einfluss des Verkippens wird auch dadurch bedingt, dass beim Verkippen der Abstand der Empfangselektrode 130 zur Wand 210 in geringerem Maße ansteigt als der Abstand der Sendeelektroden 125, 135 insgesamt zur Wand 210.

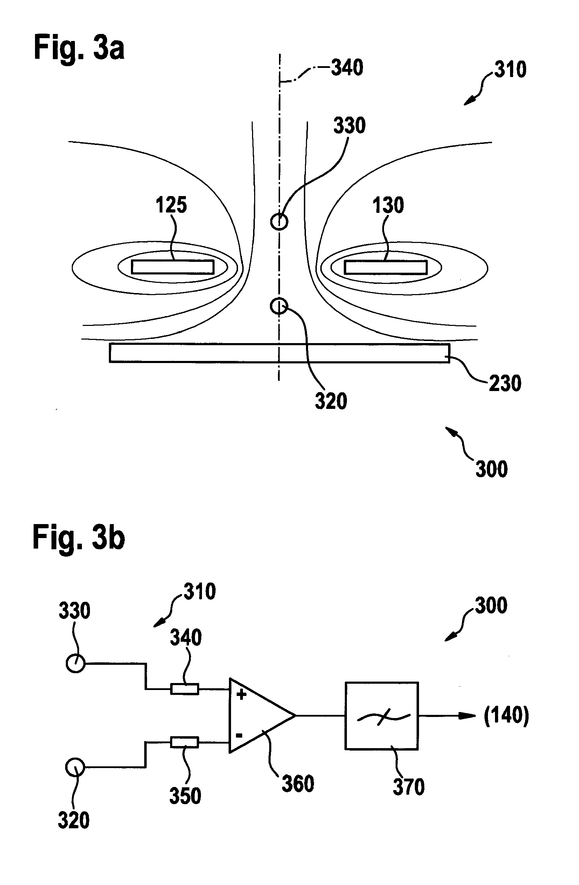

Figuren 3a und 3b zeigen eine Potentialsonde 300 für die Messvorrichtung aus Figur 1. In Figur 3a ist eine Anordnung 310 von Elektroden der Potentialsonde 300 dargestellt, in Figur 3b eine Verschaltung der Anordnung 310 mit weiteren Elementen der Potentialsonde 300. Die Potentialsonde 300 kann die Empfangselektrode 135 der Messvorrichtung 100 in Figur ersetzen.

Die Darstellung in Figur 3a entspricht der Blickrichtung in Figuren 2a-2b. Die Sendeelektroden 125 und 130 sind in einer Ebene über der Abschirmelektrode 230 angeordnet. Eine erste Empfangselektrode 320 und eine zweite Empfangselektrode 330 sind auf einer zwischen den Sendeelektroden 125 und 135 liegenden vertikalen Symmetrielinie 340 angeordnet. Abstände der Empfangselektroden 320, 330 von der Ebene der Sendeelektroden 125, 135 sind vorzugsweise gleich. Im Bereich der Sendeelektroden 125, 135 sind elektrische Äquipotentiallinien eingezeichnet. Die Empfangselektroden 320, 330 liegen auf der Potentiallinie Null; es ist jedoch bereits ausreichend, wenn die Empfangselektroden 320, 330 auf der gleichen Potentiallinie liegen. In der dargestellten Anordnung der Empfangselektroden 320, 330 auf der Symmetrielinie 340 kann mittels der Messvorrichtung 100 eine feldkompensierte Messung durchgeführt werden.

Wie in Figur 3b gezeigt ist, sind die Empfangselektroden 320, 330 über Widerstände 340 bzw. 350 mit Eingängen eines Differenzverstärkers 360 verbunden. Der Differenzverstärker 360 bildet eine Differenz der an seinen Eingängen anliegenden Spannungen (differentielle Messung). Der Ausgang des Differenzverstärkers 360 führt über einen Hochpass 370 zum Eingangsverstärker 140 in Figur 1 bzw. zu der dem Eingangsverstärker 140 vorgeschalteten Impedanz 170. Der Hochpass 370 entfernt niederfrequente Störungen, die beispielsweise durch eine potentialbehaftete oder leitfähige Wand 210 bedingt sein können.

Ein dielektrisches Objekt 220 beeinflusst hauptsächlich die erste Empfangselektrode 330, so dass die zweite Empfangselektrode 320 als Referenzpotential dient. Die Abschirmelektrode 230 ist mit einem Potential von Null (Masse) verbunden. Die Abschirmelektrode 230 kann auch mit einem beliebigen anderen Potential verbunden werden, da durch die im Differenzverstärker 360 stattfindende Subtraktion gleiche Komponenten in den zugeführten Signalen getilgt werden. Die Potentialsonde 300 selbst ist somit potentialfrei. Außerdem ist die dargestellte Potentialsonde unempfindlich gegenüber Verkippen durch die Verteilung der Elektroden 125, 135, 230, 330, 340 auf insgesamt drei Ebenen, wie oben mit Bezug auf Figuren 2a-c ausgeführt ist.

Das Ausgangssignal der Potentialsonde 300 ist abhängig von einer lateralen Position eines dielektrischen Objekts wie des Balkens 220 aus den Figuren 2a-2b. Wird der Balken 220 von rechts nach links an der Potentialsonde 300 vorbei bewegt, so ist ein am Anschluss 155 der Messvorrichtung 100 in Figur 1 anliegendes Ausgangssignal negativ, solange der Balken 220 links von der Symmetrieachse 340 liegt und positiv, sobald der Balken 220 rechts von der Symmetrieachse 340 liegt. So kann eine Kante eines großen Balkens 220 anhand von Extrema im Ausgangssignal durch Verfahren der Anordnung 310 auf der Wand 220 leicht gefunden werden. Ebenso kann die Mitte eines Balkens 220 anhand eines Vorzeichenwechsels durch Verfahren der Anordnung 310 auf der Wand 220 leicht gefunden werden.

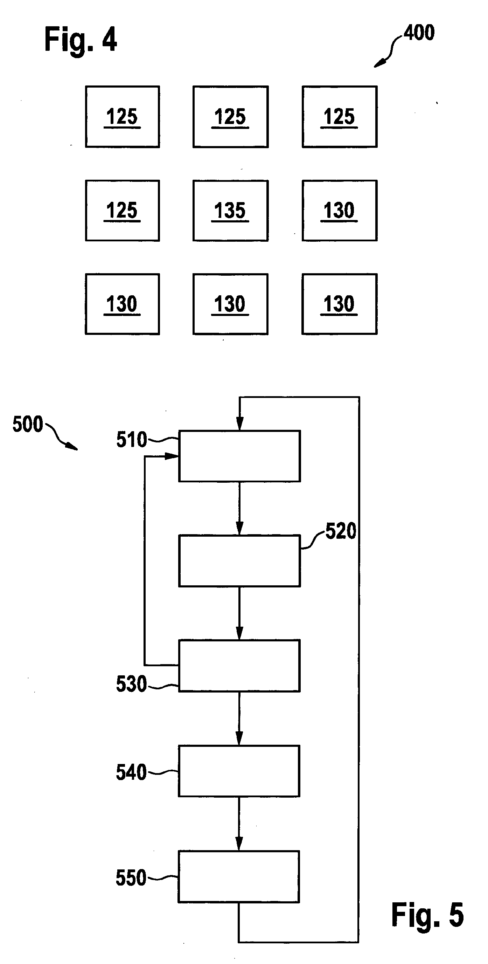

Figur 4 zeigt eine weitere Anordnung 400 von Elektroden zur Verwendung mit der Messvorrichtung 100 aus Figur 1. Die Anordnung 400 ist in einer Draufsicht dargestellt. Bezüglich einer Empfangselektrode 135 liegen sich erste Sendeelektroden 125 und zweite Sendeelektroden 130 paarweise gegenüber. Der gesamte Aufbau hat die Form einer 3x3-Matrix, wobei das mittlere Element durch die Empfangselektrode 135 gebildet ist.

Nacheinander können unterschiedliche Paare einander gegenüberliegender Sendeelektroden 125, 130 mit der Messvorrichtung 100 aus Figur 1 im Drei-Elektroden-Messbetrieb verbunden werden. Da eine Polarität des Ausgangssignals der Messvorrichtung am Anschluss 155 im Drei-Elektroden-Messbetrieb von einer lateralen Richtung des dielektrischen Objekts bezüglich der Empfangselektrode abhängig ist, kann durch die mehreren aufeinander folgenden Messungen die Richtung des dielektrischen Objekts genau bestimmt werden.

In einer weiteren Ausführungsform können die Elektroden 125, 130 auf den Diagonalen der Anordnung 400 entfallen, so dass die verbleibenden Elektroden 125-135 in Form eines Plus-Zeichens angeordnet sind. Die Anordnung 400 kann, wie oben mit Bezug auf Figur 2 beschrieben ist, in Verbindung mit einer Abschirmelektrode 230 auf einer dem dielektrischen Objekt abgewandten Seite der Elektroden 125, 135 verwendet werden.

## Patentansprüche

1. Messvorrichtung (100) zur Erfassung eines dielektrischen Objekts (220), wobei die Messvorrichtung (100) folgendes umfasst:
- eine Potentialsonde (135, 300) zum Bestimmen eines elektrischen Potentials in einem elektrischen Feld;
- eine erste und eine zweite Kapazitätseinrichtung (125, 130);
- eine Steuereinrichtung (110-120, 140-160) zur Versorgung der ersten und zweiten Kapazitätseinrichtung (125, 130) mit alternierenden Spannungen;
- wobei die Steuereinrichtung (110-120, 140-160) dazu eingerichtet ist, die alternierenden Spannungen zueinander gegenläufig zu verstärken, um einen zu den alternierenden Spannungen taktsynchronen Wechselspannungsanteil einer mittels der Potentialsonde (135, 300) aufgenommene Spannung betragsmäßig zu minimieren,
**dadurch gekennzeichnet, dass**
- die Steuereinrichtung (110-120, 140-160) dazu eingerichtet ist, das dielektrische Objekt (220) zu erfassen, wenn das Verhältnis der alternierenden Spannungen nicht zum Verhältnis der Abstände der Potentialsonde (135, 300) zu den Kapazitätseinrichtungen (125, 130) korrespondiert.

2. Messvorrichtung (100) nach Anspruch 1, **dadurch gekennzeichnet, dass** jede der Kapazitätseinrichtungen eine Elektrode (125, 130) umfasst, die zusammen mit einer Elektrode (320, 330) der Potentialsonde (135, 300) eine Kapazität bildet.

3. Messvorrichtung (100) nach Anspruch 2, **dadurch gekennzeichnet, dass** die Elektroden (125, 130) der ersten und zweiten Kapazitätseinrichtung im Wesentlichen in einer Ebene angeordnet sind und die Elektrode (320, 330) der Potentialsonde (135, 300) außerhalb dieser Ebene angeordnet ist.

4. Messvorrichtung (100) nach Anspruch 3, **dadurch gekennzeichnet, dass** die Potentialsonde (135, 300) zwei mit einem Differenzverstärker (360) verbundene Empfangselektroden (320, 330) umfasst, wobei die Empfangselektroden (320, 330) auf unterschiedlichen Seiten der Ebene mit gleichen Abständen zur ersten und zweiten Kapazitätseinrichtung (125, 130) angeordnet sind.

5. Messvorrichtung (100) nach einem der vorangehenden Ansprüche, **dadurch gekennzeichnet, dass** auf einer von dem dielektrischen Objekt (220) abgewandten Seite wenigstens einer der Kapazitätseinrichtungen (125, 130) eine Abschirmelektrode (230) angeordnet ist, die mit einem Potential verbunden ist, das mittig zwischen den alternierenden Spannungen liegt.

6. Messvorrichtung (100) nach einem der vorangehenden Ansprüche, **dadurch gekennzeichnet, dass** eine der Kapazitätseinrichtungen (125, 130) derart aufgebaut ist, dass die zwischen dieser Kapazitätseinrichtung (125, 130) und der Potentialsonde (135, 300) bestehende Kapazität von dem dielektrischen Objekt (220) unabhängig ist.

7. Messvorrichtung (100) nach einem der vorangehenden Ansprüche, **gekennzeichnet durch** ein Kompensationsnetzwerk (165) zur Veränderung wenigstens einer der **durch** die Kapazitätseinrichtungen bereitgestellten Kapazitäten um einen von dem dielektrischen Objekt (220) unabhängigen Betrag.

8. Messvorrichtung (100) nach einem der Ansprüche 2 bis 7, **dadurch gekennzeichnet, dass** eine Vielzahl Elektrodenpaare (125, 130) der Kapazitätseinrichtungen vorgesehen sind, die sich paarweise auf unterschiedlichen Seiten der Potentialsonde (135, 300) befinden, wobei die Steuereinrichtung (110-120, 140-160) dazu eingerichtet ist, wenigstens eines von einer Größe, einer Ausdehnung, einer Entfernung und einer Richtung des dielektrischen Objekts (220) auf der Basis von Differenzen der alternierenden Spannungen zu bestimmen, wenn unterschiedliche Elektrodenpaare (125, 130) mit den alternierenden Spannungen versorgt sind.

9. Messvorrichtung (100) nach Anspruch 8, **dadurch gekennzeichnet, dass** die Elektroden (125, 130) der Elektrodenpaare in einer Ebene matrixartig um die Potentialsonde (165, 300) herum angeordnet sind.

10. Verfahren (500) zur Erfassung eines dielektrischen Objekts (220), folgende Schritte umfassend:
- Bestimmen (520) eines elektrischen Potentials in einem elektrischen Feld mittels einer Potentialsonde (135, 300);
- Versorgen (510) zweier Kapazitätseinrichtungen (125, 130) mit gegenläufig verstärkten alternierenden Spannungen derart, dass ein zu den alternierenden Spannungen taktsynchroner Wechselspannungsanteil des bestimmten elektrischen Potentials betragsmäßig minimiert ist;
- Erfassen (550) des dielektrischen Objekts (220), wenn das Verhältnis der alternierenden Spannungen nicht zum Verhältnis der Abstände der Potentialsonde (135, 300) zu den Kapazitätseinrichtungen (125, 130) korrespondiert.

11. Computerprogrammprodukt mit Programmcodemitteln zur Durchführung des Verfahrens von Anspruch 10, wenn das Computerprogrammprodukt auf einer Verarbeitungseinrichtung abläuft oder auf einem computerlesbaren Datenträger gespeichert ist.

## Claims

1. Measuring device (100) for detecting a dielectric object (220), wherein the measuring device (100) comprises the following:
- a potential probe (135, 300) for determining an electrical potential in an electric field;
- a first and a second capacitance device (125, 130);
- a control device (110-120, 140-160) for supplying the first and second capacitance device (125, 130) with alternating voltages;
- wherein the control device (110-120, 140-160) is designed to amplify the alternating voltages in opposite directions to one another in order to minimize the magnitude of an alternating voltage component, which is clock-synchronous with the alternating voltages, of a voltage which is recorded by means of the potential probe (135, 300),
**characterized in that**
- the control device (110-120, 140-160) is designed to detect the dielectric object (220) when the ratio of the alternating voltages does not correspond to the ratio of the distances of the potential probe (135, 300) from the capacitance devices (125, 130).

2. Measuring device (100) according to Claim 1, **characterized in that** each of the capacitance devices comprises an electrode (125, 130) which forms a capacitance together with an electrode (320, 330) of the potential probe (135, 300).

3. Measuring device (100) according to Claim 2, **characterized in that** the electrodes (125, 130) of the first and second capacitance device are arranged substantially in one plane and the electrode (320, 330) of the potential probe (135, 300) is arranged outside this plane.

4. Measuring device (100) according to Claim 3, **characterized in that** the potential probe (135, 300) comprises two receiving electrodes (320, 330) connected to a differential amplifier (360), wherein the receiving electrodes (320, 330) are arranged on different sides of the plane with equal distances from the first and second capacitance device (125, 130).

5. Measuring device (100) according to one of the preceding claims, **characterized in that** a screening electrode (230), which is connected to a potential which lies centrally between the alternating voltages, is arranged on a side of at least one of the capacitance devices (125, 130) which faces away from the dielectric object (220).

6. Measuring device (100) according to one of the preceding claims, **characterized in that** one of the capacitance devices (125, 130) is designed in such a way that the capacitance which exists between this capacitance device (125, 130) and the potential probe (135, 300) is independent of the dielectric object (220).

7. Measuring device (100) according to one of the preceding claims, **characterized by** a compensation network (165) for changing at least one of the capacitances provided by the capacitance devices by an amount which is independent of the dielectric object (220).

8. Measuring device (100) according to one of Claims 2 to 7, **characterized in that** a multiplicity of electrode pairs (125, 130) of the capacitance devices, which are located in pairs on different sides of the potential probe (135, 300), is provided, wherein the control device (110-120, 140-160) is designed to determine at least one of a magnitude, an extension, a distance and an orientation of the dielectric object (220) based on differences of the alternating voltages when different electrode pairs (125, 130) are supplied with the alternating voltages.

9. Measuring device (100) according to Claim 8, **characterized in that** the electrodes (125, 130) of the electrode pairs are arranged in the form of a matrix in one plane around the potential probe (165, 300).

10. Method (500) for detecting a dielectric object (220) comprising the following steps:
- determination (520) of an electrical potential in an electric field by means of a potential probe (135, 300);
- supply (510) of two capacitance devices (125, 130) with alternating voltages which are amplified in opposite directions in such a way that the magnitude of an alternating voltage component, which is clocksynchronous with the alternating voltages, of the determined electrical potential is minimized;
- detection (550) of the dielectric object (220) when the ratio of the alternating voltages does not correspond to the ratio of the distances of the potential probe (135, 300) from the capacitance devices (125, 130).

11. Computer program product having program code means for carrying out the method of Claim 10 when the computer program product runs on a processing device or is stored on a computer-readable data medium.

## Revendications

1. Dispositif de mesure (100) permettant de détecter un objet diélectrique (220), le dispositif de mesure (100) comportant ce qui suit :
une sonde de potentiel (135, 300) qui détermine le potentiel électrique dans un champ électrique,
un premier et un deuxième dispositif à capacité (125, 130),
un dispositif de commande (110-120, 140-160) qui alimente en tensions alternatives le premier et le deuxième dispositif à capacité (125, 130),
le dispositif de commande (110-120, 140-160) étant conçu pour renforcer mutuellement les tensions alternatives pour minimiser le niveau de la fraction alternative synchrone des tensions alternatives de la tension enregistrée au moyen de la sonde de potentiel (135, 300),
**caractérisé en ce que**
le dispositif de commande (110-120, 140-160) est conçu pour détecter l'objet diélectrique (220) lorsque le rapport entre les tensions alternatives ne correspond pas au rapport entre les distances des sondes de potentiel (135, 300) par rapport au dispositif à capacité (125, 130).

2. Dispositif de mesure (100) selon la revendication 1, **caractérisé en ce que** chacun des dispositifs à capacité comporte une électrode (125, 130) qui forme une capacité avec une électrode (320, 330) de la sonde de potentiel (135, 300).

3. Dispositif de mesure (100) selon la revendication 2, **caractérisé en ce que** les électrodes (125, 130) du premier et du deuxième dispositif à capacité sont disposées essentiellement dans un même plan et **en ce que** les électrodes (320, 330) de la sonde de potentiel (135, 300) sont disposées à l'extérieur de ce plan.

4. Dispositif de mesure (100) selon la revendication 3, **caractérisé en ce que** la sonde de potentiel (135, 300) comprend deux électrodes réceptrices (320, 330) raccordées à un amplificateur différentiel (360), les électrodes réceptrices (320, 330) étant disposées sur des côtés différents du plan à même distance du premier et du deuxième dispositif à capacité (125, 130).

5. Dispositif de mesure (100) selon l'une des revendications précédentes, **caractérisé en ce qu'**une électrode de blindage (230) raccordée à un potentiel situé au milieu entre les tensions alternatives est disposée sur un côté non tourné vers l'objet diélectrique (220) d'au moins l'un des dispositifs à capacité (125, 130).

6. Dispositif de mesure (100) en ce que l'un des dispositifs à capacité (125, 130) est construit de telle sorte que la capacité formée entre ce dispositif à capacité (125, 130) et la sonde de potentiel (135, 300) soit indépendante de l'objet diélectrique (220).

7. Dispositif de mesure (100) selon l'une des revendications précédentes, **caractérisé par** un réseau de compensation (165) qui modifie d'une valeur indépendante de l'objet diélectrique (220) au moins l'une des capacités réalisées par les dispositifs à capacité.

8. Dispositif de mesure (100) selon l'une des revendications 2 à 7, **caractérisé en ce que** plusieurs paires d'électrodes (125, 130) des dispositifs à capacité sont prévues par paires sur des côtés différents de la sonde de potentiel (135, 300), le dispositif de commande (110-120, 140-160) étant conçu pour déterminer la taille, l'extension, la distance et/ou la direction de l'objet diélectrique (220) sur la base des différences entre les tensions alternatives lorsque des paires d'électrodes différentes (125, 130) sont alimentées en tensions alternatives.

9. Dispositif de mesure (100) selon la revendication 8, **caractérisé en ce que** les électrodes (125, 130) des paires d'électrodes sont disposées dans un plan, en matrice autour de la sonde de potentiel (165, 300).

10. Procédé (500) de détection d'un objet diélectrique (220), le procédé présentant les étapes suivantes :
déterminer (520) le potentiel électrique d'un champ électrique au moyen d'une sonde de potentiel (135, 300),
alimenter (510) deux dispositifs à capacité (125, 130) par des tensions alternatives amplifiées en sens contraire de manière à minimiser le niveau de la partie alternative synchrone par rapport aux tensions alternatives du potentiel électrique déterminé et
détecter (550) l'objet diélectrique (220) lorsque le rapport entre les tensions alternatives ne correspond pas au rapport entre les distances des sondes de potentiel (135, 300) par rapport au dispositif à capacité (125, 130).

11. Produit de programme informatique doté de moyens de code de programme permettant de mettre en oeuvre le procédé selon la revendication 10 lorsque le produit de programme informatique est exécuté sur un dispositif de traitement ou est conservé sur un support de données lisibles par ordinateur.
